# EUROPEAN PATENT SPECIFICATION

(11) **EP 0 777 407 B1**
(45) Date of publication and mention of the grant of the patent: **09.04.2003**
(21) Application number: 96118923.0
(22) Date of filing: 26.11.1996
(51) Int. Cl.: H05K 5/06

(54) **Method of hermetically sealing a container of electromechanical components and sealed container thus obtained**
Verfahren zur Abdichtung eines Gehäuses für elektromagnetische Bauteile und so abgedichtetes Gehäuse
Méthode pour rendre hermétiquement étanche un boîtier contenant des composants électromagnétiques et boîtier étanche obtenu par celle-ci

(30) Priority: 28.11.1995 IT TO950950
(43) Date of publication of application: 04.06.1997
(73) Proprietor: Automotive Lighting Italia Spa, 10078 Venaria Reale (Torino) (IT)
(72) Inventor: Portoso, Mauro, 10090 Sangano (IT); Todesco, Floriano, 10093 Collegno (IT); Lando, Claudio, 20137 Milano (IT)
(74) Representative: Plebani, Rinaldo

(56) References cited:
- DE-A- 4 407 967
- GB-A- 975 059
- GB-A- 2 115 084

## Description

The present invention relates to a method of assembling two elements obtaining a container of electromechanical components hermetically sealed and suitable to support loads able to separate the two elements forming the container itself, and to the sealed container thus obtained, and more particularly relates to a method for joining together in a leaktight and irreversible manner, two polymeric resin half-shells intended to enclose and protect the electromechanical components from external contaminating liquids and agents, using as adhesive bonding component an elastomeric resin which is chemically compatible with the resin of the half-shells and is able to form a continuous sealing bead, adhering intimately to both half-shells.

According to what is known in the state of the art concerning processes for hermetically joining two half-shells in order to form a single leaktight container, various solutions are in evidence, among which may be mentioned that of arranging a sealing bead element on the edge of each half-shell and joining the two half-shells with mechanical fastening means; another known method provides for employing an elastomer sealing bead element fixed on a first half-shell by mechanical seaming and joining the first to a second half-shell by means of a snap-fastening device; yet another known method for leaktightly joining two half-shells consists in welding together the two half-shells by ultrasound or by the so called "hot plate" method.

As those skilled in the art will readily understand, the methods currently known in the art and recalled above, as well as that one known from GB975059 provide for employing mechanical means for the mutual clamping of the half-shells, or alternatively, processes for welding one half-shell directly to the other, which are complex from the point of view of assembly and require highly elaborate and hence more expensive moulds, in order to mould the half-shells provided with the necessary structural elements able to house the various mechanical clamping means.

Moreover, such methods of joining two half-shells do not a priori ensure perfect impermeability to infiltration by extraneous contaminating liquids and/or particles, specifically they do not ensure the continuance of leaktightness over time, when the device is in use.

The object of the present invention is to propose a method of hermetically sealing two half-shells forming a leaktight container for electromechanical components assuring simultaneously the structural continuity between the parties, and which overcomes the drawbacks exhibited by the methods currently in use in the art.

Hence, there is proposed a method according to claim 1.

There is moreover proposed a container for electromechanical components which is leaktightly sealed, in accordance with the method according to the present invention and Claim 6.

This and other characteristics of the invention will emerge more clearly from the following description of a preferred implementation of the proposed method and of the resulting sealed container, given by way of non-limiting example with reference to the appended drawings in which:
Figure 1 represents a partially sectioned elevation of a container for electromechanical components sealed and assembled with structural continuity between the half-shells in accordance with the method proposed by the present invention;
Figure 2 represents in section an enlarged-scale detail of the joining region of the container of Figure 1;
Figure 3 represents in section the same detail as Figure 2, in which the half-shells are represented in a spaced-apart position, for greater clarity.

With reference to the figures, 1 indicates a container with leaktight closure able to accommodate electromechanical components indicated for simplicity as a block 2, which by their nature require an environment which is perfectly sheltered from contaminating agents, whether liquid or solid. Such components can, according to one non-limiting example, be electric motors, electronic circuits for controlling motors, control and regulating components, such as for example potentiometers and/or relays, etc.

In particular, according to a preferred embodiment, the container 1 is intended to accommodate an electromechanical device for monitoring and correcting the trim of the headlights of an automobile, comprising at least one electronic circuit CT for monitoring an electric motor ME, able to vary the trim of the headlights in a known manner, via the axial movement of a rod AT, moved by the motor ME and exiting from a wall of the container through a sealing bush BT; a connector CN able to receive the electrical connections necessary for the operation of the contained components can be associated integrally with the container.

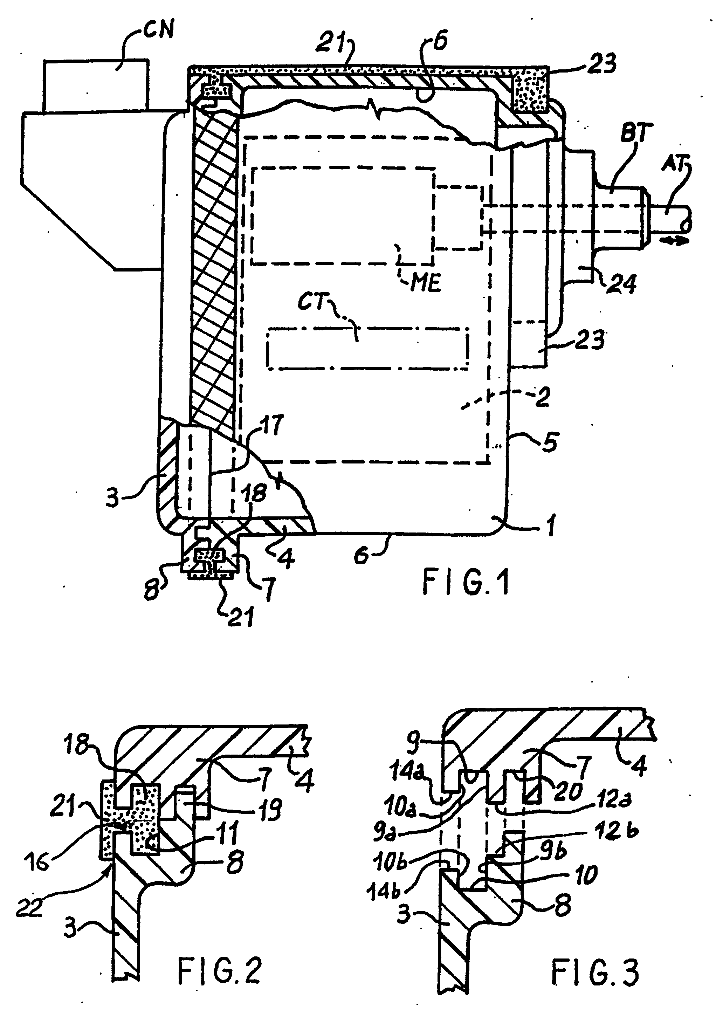

The container 1 consists substantially of two half-shells 3 and 4, made from a polymeric resin, for example polypropylene or polyamide. The two half-shells 3 and 4 can be specularly identical, consisting of an end wall 5 and four side walls 6, which terminate in an edge 7 of increased thickness with respect to that of the side walls 6; as a non-limiting alternative, as illustrated in Figure 1, one of the half-shells, for example the half-shell 3, can have the form of a cover (Fig. 1) provided with its own edge 8 of increased thickness, similar to the edge 7 of the other half-shell, and of complementary form, such as to be superimposable and to mate exactly.

The edges 7, 8 of the half-shells are machined such that they each exhibit an open grooved annular seat 9 and 10 respectively; the two grooved seats 9, 10 extend continuously along the whole run of the edges 7 and 8 and are arranged mutually facing one another in a substantially middle position with respect to the transverse dimension of each edge, such that, when the two half-shells 3 and 4 are joined, they form a single closed grooved seat 11 common to and included within the edges 7 and 8 of the said half-shells.

The grooved seats 9 and 10 are delimited by two pairs of lateral walls (Fig. 3); 9a, 9b indicate the side walls on the inward side with respect to the grooved seats; 10a and 10b respectively indicate those arranged outside; the pairs of side walls 9a, 9b and 10a, 10b terminate in pairs of strip-like plane, inside front surfaces 12a, 12b and outside front surfaces 14a, 14b respectively, which extend throughout their run, and are able to be placed facing in pairs when the two half-shells 3 and 4 are joined. The overhang of the two inside front surfaces 12a and 12b is dimensioned such that the half-shells 3 and 4 abut only thereon, when the shells are joined.

The plane outside front surfaces 14a and 14b, outside the seats 9,10, are made with a smaller overhang than that of the counterpart inside surfaces, so that, with the half-shells joined, the abovementioned plane surfaces 14a and 14b are spaced somewhat apart so as to create a channel consisting of a continuous crevice 16 extending along the joining region 17 of the half-shells and communicating on the one hand with the outside environment and on the other hand with the closed grooved seat 11.

It is therefore possible to inject, through the crevice 16, into the grooved seat 11 an elastomeric resin which is chemically compatible with the resin of the half-shells, in order to form a sealing bead 18 (Fig. 2), which hermetically seals together the half-shells assuring the structural continuity of the same, according to the method of the present invention, described below.

One of the two edges, for example the edge 8, is provided with a rib 19 in relief, arranged adjacent to the inside front surface 12b and extending continuously over the whole run of the edge 8; similarly on the edge 7 of the other half-shell 4 there is made a groove 20 adjacent to the surface 12a and able to accommodate the rib 19, when the half-shells are joined, so as to create a positioning reference and a barrier against possible infiltrations of extraneous matter into the coupled half-shells.

Hence, the method according to the present invention for hermetically and structurally sealing together the two half-shells 3 and 4 proceeds as follows.

After having inserted the electromechanical components to be protected, the half-shells 3 and 4 are joined, inserting the rib 19 into the corresponding groove 20, so that the surfaces 12a and 12b abut; the container thus closed is inserted into an injection mould, not shown, and then an elastomeric resin, chemically alike the resin of the container 1, is injected into the mould; the injected resin penetrates through the crevice 16 into the closed grooved seat 11 in order to form a sealing bead 18 of resin, which during the subsequent phase of hardening, by polymerization and/or curing, creates stable molecular bonds between the polymeric resin of the container 1 and the elastomeric resin of the bead 18.

In this way the container 1 becomes hermetically sealed and the components contained therein remain protected from any outside contaminating agent and, simultaneously, an irreversible (save for the breaking of the components) stable mechanical connection is produced between the half-shells, comparable to adhesive bonding.

With the object of facilitating the injection of the material intended to form the sealing bead 18, and/or in order to facilitate the fixing of the sealed container when in use on a support structure of an automobile, the mould can be shaped, for example, in such a way as to deposit a strip 21 of elastomeric resin of between 0.5 and 1 mm in thickness on the outside surface 22 of the container 1, arranged simmetrically along the joining region 17 of the half-shells, and united with continuity of the material with the forming sealing bead 18 contained in the crevice 16. Similarly, further depositions of elastomeric resin may be carried out on other regions of the outside surface 22 of the container 1, in order to form layers or beads of resin acting as sealing beads and non-rigid supports, for example in order to create a sealing ring 23 around an exit collar 24 of the rod AT of the motor ME; such a collar 24, by virtue of the strip 21, can be obtained through a single injection operation together with the sealing bead 18.

## Claims

1. Method for realizing an hermetically sealed container (1) comprising two polymeric resin half-shells (3,4) each delimited by a corresponding edge (7;8), assuring the structural continuity between said half-shells (3,4), the method comprising the steps of:
a) creating complementary open grooved seats (9,10) on facing front surfaces (12a,14a;12b,14b) of said corresponding edges (7;8)of said first and second half-shells (3,4), the said seats (9,10) being provided with at least one channel communicating with the outside;
b) uniting the said half-shells (3,4), while arranging the said open grooved seats (9,10) mutually facing one another, in order to form a single closed grooved seat (11), common to both the united edges (7,8) of said half shells (3,4) and communicating with the outside through said at least one channel;
c) injecting into said closed grooved seat (11) an elastomeric resin able to create stable molecular bonds with the polymeric resin of said half-shells (3,4);
d) leaving the injected resin to harden, by polymerization and/or curing, for a time sufficient to form inside said closed grooved seat (11) a sealing bead (18);
**characterized in that**
(i)- said at least one channel consists of a continuous crevice (16) extending all along a joining region (17) of the said half-shells (3,4) and interposed between the said closed grooved seat (11) and the outside environment;
(ii)- said method further comprising the step of:
e) inserting the said united half-shells (3,4) into an injection mould;
(iii)- said injection step (c) being carried out inside said injection mould and through said crevice (16), so as that said sealing bead (18) at the same time leaktight seals said half-shells ((3,4) together and structurally connects said half-shells (3,4) to one another in an irreversible manner, to form said container (1), by means of said stable molecular bonds between the elastomeric resin forming the bead (18) and the polymeric resin of said half-shells (3,4).

2. Method as claimed in claim 1, wherein said half-shells (3,4) are able to accommodate electromechanical components (2) for automobiles.

3. Method according to claim 1 or 2, **characterized in that** step (c) comprises the operation of injecting the said elastomeric resin simultaneously over at least part of an outside surface (22) of at least one of the said half-shells (3,4), in order to form a strip (21) of predetermined thickness, securely anchored to said sealing bead (18).

4. Method according to Claim 3, **characterized in that** the said outer surface (22) is arranged symmetrically along said joining region (17) of the said half-shells (3,4).

5. Method according to anyone of the foregoing claims, **characterized in that** the said open grooved seats (9:10) are delimited by two pairs of side walls (9a, 9b; 10a, 10b), the walls of a first pair (9a, 9b) inside with respect to the said grooved seat, being dimensioned so as to come, in said step (b), into mutual frontal contact in order to bring respective front surfaces (12a;12b) of the said half-shells (3;4) in abutment; the walls of a second pair (10a, 10b), outside with respect to the said open grooved seat (9,10), being spaced apart frontally in order to form said crevice (16).

6. Hermetically sealed container (1), in particular for housing hermetically electromechanical components (2) for automobiles, obtained according to the method set forth in anyone of the preceding claims, the container (1) comprising: two polymeric resin half-shells (3,4) each delimited by a corresponding edge (7;8), assuring the structural continuity between said half-shells (3,4); complementary open grooved seats (9,10) created on facing front surfaces (12a,14a;12b,14b) of said corresponding edges (7;8) of said first and second half-shells (3,4), the said seats (9,10) being provided with at least one channel communicating with the outside and said edges (7,8) being united with the said open grooved seats (9,10) mutually facing one another, in order to form a single closed grooved seat (11), common to both the united edges (7,8) of said half shells (3,4) and communicating with the outside through said at least one channel; inside said closed grooved seat (11) a sealing bead (18) being provided;
**characterized in that**
(i)- said at least one channel consists of a continuous crevice (16) extending all along a joining region (17) of the said half-shells (3,4) and interposed between the said closed grooved seat (11) and the outside environment;
(ii)- said sealing bead (18) having been obtained by injecting into said closed grooved seat (11) and through said crevice (16) an elastomeric resin able to create stable molecular bonds with the polymeric resin of said half-shells (3,4) and by leaving the injected resin to harden, by polymerization and/or curing, inside a mold;
(iii)- said sealing bead (18) at the same time leaktight seals said half-shells ((3,4) together and structurally connects said half-shells (3,4) to one another in an irreversible manner, to form said container (1), by means of said stable molecular bonds between the elastomeric resin forming the bead (18) and the polymeric resin of said half-shells (3,4).

## Patentansprüche

1. Verfahren für die Herstellung eines hermetisch abgedichteten Behälters (1), der zwei Polymerharz-Halbschalen (3, 4) umfaßt, wovon jede durch eine entsprechende Kante (7; 8) begrenzt ist, die die strukturelle Kontinuität zwischen den Halbschalen (3, 4) sicherstellt, wobei das Verfahren die folgenden Schritte umfaßt
(a) Erzeugen komplementärer offener Nutsitze (9, 10) in einander zugewandten Stirnflächen (12a, 14a; 12b, 14b) der entsprechenden Kanten (7; 8) der ersten und der zweiten Halbschale (3, 4), wobei die Sitze (9, 10) mit wenigstens einem Kanal versehen sind, die mit der äußeren Umgebung in Verbindung steht;
(b) Vereinigen der Halbschafen (3, 4), wobei dle offenen Nutsitze (9, 10) einander zugewandt angeordnet sind, um einen einzigen geschlossenen Nutsitz (11) zu bilden, der beiden vereinigten Kanten (7, 8) der Halbschalen (3, 4) gemeinsam ist und mit der äußeren Umgebung durch den wenigstens einen Kanal in Verbindung steht;
(c) Einspritzen eines Elastomerharzes, das stabile molekulare Bindungen mit dem Polymerharz der Halbschalen (3, 4) erzeugen kann, in den geschlossenen Nutsitz (11);
(d) Härtenlassen des eingespritzten Harzes durch Polymerisation und/oder Aushärten während einer Dauer, die ausreicht, um in dem geschlossenen Nutsitz (11) einen Dichtungswulst (18) zu bilden;
**dadurch gekennzeichnet, daß**
(i) - der wenigstens eine Kanal aus einem ununterbrochenen Spalt (16) besteht, der sich längs eines gesamten Verbindungsbereichs (17) der Halbschalen (3, 4) erstreckt und zwischen dem geschlossenen Nutsitz (11) und der äußeren Umgebung angeordnet ist;
(ii) - das Verfahren ferner die folgenden Schritte umfaßt:
(e) Einsetzen der vereinigten Halbschalen (3, 4) in eine Druckgußform;
(iii) - der Einspritzschritt (c) in der Druckgußform und durch den Spalt (16) ausgeführt wird, so daß der Dichtungswulst (18) gleichzeitig die Halbschalen (3, 4) leckdicht abdichtet und sie mittels der stabilen molekularen Bindungen zwischen dem den Wulst (18) bildenden Elastomerharz und dem Polymerharz der Halbschalen (3, 4) strukturell miteinander in unumkehrbarer Weise verbindet, um den Behälter (1) zu bilden.

2. Verfahren nach Anspruch 1, bei dem die Halbschalen (3, 4) elektromechanische Komponenten (2) für Kraftfahrzeuge aufnehmen können.

3. Verfahren nach Anspruch 1 oder 2, **dadurch gekennzeichnet, daß** der Schritt (c) den Vorgang des Einspritzens des Elastomerharzes gleichzeitig wenigstens über einen Teil der äußeren Oberfläche (22) wenigstens einer der Halbschalen (3, 4) umfaßt, um einen Streifen (21) mit vorgegebener Dicke zu bilden, der an dem Dichtungswulst (18) sicher verankert ist.

4. Verfahren nach Anspruch 3, **dadurch gekennzeichnet, daß** die äußere Oberfläche (22) längs des Verbindungsbereichs (17) der Halbschalen (3, 4) symmetrisch angeordnet ist.

5. Verfahren nach einem der vorhergehenden Ansprüche, **dadurch gekennzeichnet, daß** die offenen Nutsitze (9; 10) durch zwei Paare von Seitenwänden (9a, 9b; 10a, 10b) begrenzt sind, wobei die Wände eines ersten Paars (9a, 9b), die sich in bezug auf den Nutsitz innen befinden, so bemessen sind, daß sie im Schritt (b) in einen gegenseitigen stirnseitigen Kontakt gelangen, um jeweilige Stirnflächen (12a; 12b) der Halbschalen (3; 4) in gegenseitigen Anschlag zu bringen; wobei die Wände eines zweiten Paars (10a, 10b), die sich außerhalb des offenen Nutsitzes (9, 10) befinden, stimseitig voneinander beabstandet sind, um den Spalt (16) zu bilden.

6. Hermetisch dichter Behälter (1), insbesondere für die Unterbringung hermetischer elektromechanischer Komponenten (2) für Kraftfahrzeuge, der gemäß dem Verfahren nach einem der vorhergehenden Ansprüche erhalten wird und umfaßt: zwei Polymerharz-Halbschalen (3, 4), wovon jede durch eine entsprechende Kante (7; 8) begrenzt ist, die die strukturelle Kontinuität zwischen den Halbschalen (3, 4) sicherstellt; komplementäre offene Nutsitze (9, 10), die auf einander zugewandten Stirnflächen (12a, 14a; 12b, 14b) der entsprechenden Kanten (7; 8) der ersten und der zweiten Halbschale (3, 4) erzeugt worden sind, wobei die Sitze (9, 10) mit wenigstens einem Kanal versehen sind, der eine Verbindung mit der äußeren Umgebung herstellt, und die Kanten (7, 8) mit den offenen Nutsitzen (9, 10), die einander zugewandt sind, vereinigt sind, um einen einzigen geschlossenen Nutsitz (11) zu bilden, der beiden vereinigten Kanten (7, 8) der Halbschalen (3, 4) gemeinsam ist und mit der äußeren Umgebung durch den wenigstens einen Kanal in Verbindung steht; wobei in dem geschlossenen Nutsitz (11) ein Dichtungswulst (18) vorgesehen ist;
**dadurch gekennzeichnet, daß**
(i) - der wenigstens eine Kanal aus einem ununterbrochenen Spalt (16) besteht, der sich längs des gesamten Verbindungsbereichs (17) der Halbschalen (3, 4) erstreckt und zwischen dem geschlossenen Nutsitz (11) und der äußeren Umgebung angeordnet ist;
(ii) - der Dichtungswulst (18) erhalten wird durch Einspritzen eines Elastomerharzes, das mit dem Polymerharz der Halbschalen (3, 4) stabile molekulare Bindungen erzeugen kann, in den geschlossenen Nutsitz (11) und durch den Spalt (16) sowie durch Härtenlassen des eingespritzten Harzes durch Polymerisation und/oder Aushärten in einer Gießform;
(iii) - der Dichtungswulst (18) die Halbschalen (3, 4) leckdicht abdichtet und gleichzeitig die Halbschalen (3, 4) mittels der stabilen molekularen Bindungen zwischen dem den Wulst (18) bildenden Elastomerharz und dem Polymerharz der Halbschalen (3, 4) strukturell verbindet, um den Behälter (1) zu bilden.

## Revendications

1. Procédé pour réaliser un boîtier hermétiquement étanche (1) comprenant deux demi-coques en résine polymère (3, 4), chacune délimitée par un bord correspondant (7 ; 8), assurant la continuité structurale entre lesdites demi-coques (3, 4), le procédé comprenant les étapes consistant à :
a) créer des embases rainurées ouvertes complémentaires (9, 10) en regard des surfaces avant (12a, 14a ; 12b, 14b) desdits bords correspondants (7 ; 8) desdites première et seconde demi-coques (3, 4), lesdites embases (9, 10) étant munies de au moins une rainure communiquant avec l'extérieur ;
b) unir lesdites demi-coques (3, 4), tout en disposant lesdites embases rainurées ouvertes (9, 10) mutuellement en face l'une de l'autre, afin de former une seule embase rainurée fermée (11), commune aux deux bords unis (7, B) desdites demi-coques (3, 4) et communiquant avec l'extérieur par l'intermédiaire de ladite au moins une rainure;
c) injecter dans ladite embase rainurée fermée (11) une résine élastomère capable de créer des liaisons moléculaires stables avec la résine polymère desdites demi-coques (3, 4) ;
d) laisser la résine injectée durcir, par polymérisation et/ou séchage, pendant un temps suffisant pour former à l'intérieur de ladite embase rainurée fermée (11) une bulle étanche (18) ;
**caractérisé en ce que**
(i)- ladite au moins une rainure consiste en une fente continue (16) s'étendant tout le long d'une région de joint (17) desdites demi-coques (3, 4) et interposée entre ladite embase rainurée fermée (11) et l'environnement extérieur ;
(ii) ledit procédé comprenant, en outre, les étapes consistant à
e) insérer lesdites demi-coques unies (3, 4) dans un moule d'injection ;
(iii) ladite étape d'injection (c) étant exécutée à l'intérieur dudit moule d'injection et par l'intermédiaire de ladite fente (16), de sorte que ladite bulle étanche (18), au même moment, rend hermétiquement étanche lesdites demi-coques (3, 4) et relie ensemble et structurellement lesdites demi-coques (3, 4) l'une à l'autre d'une manière irréversible pour former ledit boîtier (1), au moyen desdites liaisons moléculaires stables entre la résine élastomère formant la bulle (18) et la résine polymère desdites demi-coques (3, 4).

2. Procédé comme revendiqué dans la revendication 1, dans lequel lesdites demi-coques (3, 4) sont capables de s'accommoder aux composants électromécaniques (2) pour automobiles.

3. Procédé en conformité avec la revendication 1 ou 2, **caractérisé en ce que** cette étape (c) comprend l'opération d'injecter ladite résine élastomère simultanément sur au moins la partie d'une surface extérieure (22) d'au moins une desdites demi-coques (3, 4) afin de former une bande (21) d'épaisseur prédéterminée, fermement ancrée à ladite bulle étanche (18).

4. Procédé en conformité avec la revendication 3, **caractérisé en ce que** ladite surface externe (22) est disposée symétriquement le long de ladite région de joint (17) desdites demi-coques (3, 4).

5. Procédé en conformité avec l'une quelconque des revendications précédentes, **caractérisé en ce que** lesdites embases rainurées ouvertes (9, 10) sont délimitées par deux paires de parois de côté (9a, 9b ; 10a, 10b), les parois d'une première paire (9a, 9b) intérieures par rapport à ladite embase rainurée, étant dimensionnées de sorte à venir, dans ladite étape (b), dans un contact frontal mutuel afin de mettre des surfaces avant respectives (12a ; 12b) desdites coques (3 ; 4) en aboutement ; les parois d'une seconde paire (10a; 10b), extérieures par rapport à ladite embase = rainurée ouverte (9, 10) étant espacées l'une de l'autre frontalement pour former ladite fente (16).

6. Boîtier hermétiquement étanche (1), en particulier pour loger hermétiquement des composants électromécaniques (2) pour automobiles, obtenu en conformité avec le procédé exposé dans l'une quelconque des revendications précédentes, le boîtier (1) comprenant : deux demi-coques de résine polymère (3, 4), chacune délimitée par un bord correspondant (7 ; 8) assurant la continuité structurelle entre lesdites demi-coques (3, 4) ; des embases rainurées ouvertes complémentaires (9, 10) créées sur les surfaces avant se faisant face (12a, 14a ; 12b, 14b) desdits bords correspondants (7 ; 8) desdites première et seconde demi-coques (3, 4), lesdites embases (9, 10) étant munies d'au moins une rainure communiquant avec l'extérieur et lesdits bords (7, 8) étant unis avec lesdites embases rainurées ouvertes (9, 10). étant mutuellement en face l'une de l'autre, afin de former une seule embase rainurée fermée (4), commune aux deux bords unis (7, 8) desdites demi-coques (3, 4) et communiquant avec l'extérieur par l'intermédiaire de ladite au moins une rainure ; à l'intérieur de ladite embase rainurée fermée (4) une bulle étanche (18) étant fournie ;
**caractérisé en ce que**
(i)- ladite au moins une rainure consiste en une fente continue (16) s'étendant tout le long d'une région de joint (17) desdites demi-coques (3, 4) et interposée entre ladite embase rainurée fermée (11) et l'environnement extérieur ;
(ii)- ladite bulle étanche (18) ayant été obtenue par injection dans ladite embase rainurée fermée (11) et par l'intermédiaire de ladite fente (16) une résine élastomère capable de créer des liaisons moléculaires stables avec la résine polymère desdites demi-coques (3, 4) et en laissant la résine injectée durcir par polymérisation et/ou séchage, à l'intérieur d'un moule ;
(iii)- ladite bulle étanche (18), au même moment, rend hermétiquement étanche lesdites demi-coques (3, 4) et relie ensemble et structurellement lesdites demi-coques (3, 4) l'une à l'autre d'une manière irréversible pour former ledit boîtier (1), au moyen desdites liaisons moléculaires stables entre la résine élastomère formant la bulle (18) et la résine polymère desdites demi-coques (3, 4).
